# EUROPÄISCHE PATENTSCHRIFT

(11) **EP 3 346 547 B1**
(45) Veröffentlichungstag und Bekanntmachung des Hinweises auf die Patenterteilung: **03.03.2021**
(21) Anmeldenummer: 18150237.8
(22) Anmeldetag: 03.01.2018
(51) Int. Cl.: H01Q 1/22, H01Q 15/00, H01Q 15/02

(54) **MODULANORDNUNG MIT INTEGRIERTER ANTENNE UND EINGEBETTETEN KOMPONENTEN SOWIE VERFAHREN ZUR HERSTELLUNG EINER MODULANORDNUNG**
MODULE ASSEMBLY WITH INTEGRATED ANTENNA AND EMBEDDED COMPONENTS AND METHOD FOR PRODUCING A MODULE ASSEMBLY
ENSEMBLE MODULAIRE POURVU D'ANTENNE INTÉGRÉE ET DE COMPOSANTS INCORPORÉS AINSI QUE PROCÉDÉ DE FABRICATION D'UN ENSEMBLE DE MODULE

(30) Priorität: 05.01.2017 DE 102017200126
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: Ndip, Ivan, 13469 Berlin (DE); OSTMANN, Andreas, 10585 Berlin (DE)
(74) Vertreter: Hersina, Günter

(56) Entgegenhaltungen:
- DE-A1-102006 023 123
- US-A1- 2008 029 886
- US-B1- 7 522 105

## Beschreibung

Die Erfindung bezieht sich auf eine Modulanordnung und ein Verfahren zur Herstellung einer Modulanordnung.

Modulanordnungen, auf denen elektronische Komponenten aufgebracht sind, sind in vielen Bereichen der Technik bekannt und in Anwendung. Relevante und kritische Themenbereiche bei solchen Modulanordnungen sind beispielsweise die elektrische Verbindung zwischen den Komponenten, die Kontaktierung der Komponenten von außen oder die Reduktion des Platzbedarfs der Komponenten und damit auch eine Verkleinerung der Anordnung an sich. Ziel ist es oft, die Integrationsdichte zu erhöhen.

Leiterplatten (andere Bezeichnungen sind Platine, Leiterkarte oder gedruckte Schaltung, englisch printed circuit board, PCB) als mögliche Bestandteile der Modulanordnungen bestehen im Allgemeinen aus elektrisch isolierendem Material und weisen auf ihren (Ober- bzw. Unter-)Seiten elektrisch leitende Verbindungen in Form von Leiterbahnen auf.

Es sind dabei Anordnungen mit einer Leiterplatte oder mit mehreren übereinander angeordneten Leiterplatten (sog. Multilayer-Leiterplatten) bekannt. Für die Herstellung der Leiterplatten sind teilweise sog. PrePregs in Verwendung. Dabei handelt es sich um mit Harzen vorimprägnierte textile Faser-Matrix-Halbzeuge, die unter Druck und Temperatur aushärten.

Im Stand der Technik ist es bekannt, Komponenten oder beispielsweise Chips in die Leiterplatten einzufügen (englisch embedding). Unterschieden werden beispielsweise zwei grundlegende Verfahren, die sich darin voneinander unterscheiden, ob die Kontakte bzw. Pins der Komponenten entweder der Leiterplatte (sog. Face-Down-Embedding) oder von der Leiterplatte weggewandet sind (sog. Face-Up-Embedding). Dabei sind die Komponenten insbesondere im Material der Leiterplatte eingebunden (siehe z. B. DE 199 54 941 A1, DE 10 2005 032 489 B3 oder DE 694 30 765 T2).

Die US 2008 / 029 886 A1 beschreibt eine Anordnung mit einem Siliziumsubstrat, das zwei Kavitäten aufweist. In einer ersten Kavität wird ein Chip angeordnet. Eine zweite Kavität bildet einen Resonator für eine darüber angeordnete Antenne.

Die DE 10 2006 023 123 A1 beschreibt ein Halbleitermodul mit Komponenten für Höchstfrequenztechnik in einem Kunststoffgehäuse. Eine Trägerplatte weist eine Kavität auf, in der ein Chip angeordnet ist. Lateral neben dem Chip, sowie in einer zusätzlichen Schicht ober- oder unterhalb der Trägerplatte ist eine Schlitzantenne angeordnet.

Die Aufgabe der Erfindung besteht darin, eine Modulanordnung mit einer integrierten Antenne und eingebetteten Komponenten sowie ein Verfahren zur Herstellung einer solchen Modulanordnung vorzuschlagen.

Die Erfindung löst die Aufgabe durch eine Modulanordnung.

Dabei sind zwischen einer Oberseite und einer Unterseite der Modulanordnung eine Antennenvorrichtung und mindestens eine elektronische Komponente nebeneinander und in einer Ebene angeordnet. Zudem ist zwischen der Antennenvorrichtung und der mindestens einen elektronischen Komponente eine Abschirmvorrichtung vorhanden. Die Abschirmvorrichtung ist derartig ausgestaltet, dass sie eine abschirmende Wirkung gegenüber elektromagnetischen Signalen hat.

Die Antennenvorrichtung und mindestens eine elektronische Komponente befinden sich somit in einer Ebene. Dabei ragen je nach Ausgestaltung die Antennenvorrichtung und/oder die mindestens eine elektronische Komponente über die Ebene hinaus. Betrachtet man die Modulanordnung von der einen zur anderen Seite (also von der Ober- zur Unterseite oder umgekehrt), so befinden sich die Antennenvorrichtung und mindestens eine elektronische Komponente zumindest teilweise auf einer gemeinsamen Höhe oder auf einem gemeinsamen Höhenband.

Die Abschirmvorrichtung schützt die mindestens eine elektronische Komponenten oder schützt ggf. mehrere elektronische Komponenten vor den elektromagnetischen Signalen der Antennenvorrichtung. Umgekehrt wird jedoch auch verhindert, dass sich die elektronische(n) Komponente(n) möglicherweise auf die Antennenvorrichtung auswirkt bzw. auswirken.

Erfindungsgemäß handelt es sich bei der Abschirmvorrichtung um eine Reihe von Durchkontaktierungen (sog. shielding vias).

In einer Ausgestaltung ist vorgesehen, dass die Modulanordnung mindestens eine Träger-Schicht aufweist. Dabei sind die Antennenvorrichtung und die mindestens eine elektronische Komponente in der Träger-Schicht eingebettet bzw. integriert. Vorzugsweise ist auch die Abschirmvorrichtung zumindest teilweise in der Träger-Schicht befindlich bzw. eingebettet. Durch die Träger-Schicht, die die Antennenvorrichtung und die mindestens eine elektronische Komponente trägt, wird somit in dieser Ausgestaltung die Ebene definiert, in der sich die Antennenvorrichtung und die mindestens eine elektronische Komponente nebeneinander befinden. In einer Ausgestaltung handelt es sich bei der Träger-Schicht um eine Leiterplatte.

In einer Ausgestaltung verfügt die Modulanordnung über mehrere elektronische Komponenten.

In einer Ausgestaltung ist vorgesehen, dass sich zumindest die Mehrheit der elektronischen Komponenten der Modulanordnung und die Antennenvorrichtung in der gemeinsamen Ebene befinden. In einer Ausgestaltung befinden sich alle elektronischen Komponenten der Modulanordnung zusammen mit der Antennenvorrichtung in der einen Ebene.

Eine Ausgestaltung besteht darin, dass mehrere elektronische Komponenten in der Träger-Schicht eingebettet sind.

Die Träger-Schicht besteht beispielsweise aus einem Polymer, aus einem für Hochfrequenz geeigneten Laminat, aus einem Glas oder einem anderen Dielektrikum.

Eine Ausgestaltung sieht vor, dass eine Verteilungsschicht zum Verteilen von elektrischer Energie und/oder elektrischen Signalen vorhanden ist. Diese Ausgestaltung erlaubt es, die Verbindung zwischen den elektronischen Komponenten und/oder zwischen den Komponenten und der Antennenvorrichtung innerhalb der Modulanordnung zu realisieren.

Eine Ausgestaltung besteht darin, dass Kontakte zur Kontaktierung der Modulanordnung auf einer Unterseite der Modulanordnung zusammengeführt sind. In dieser Ausgestaltung sind die Kontaktierungsmöglichkeiten der Modulanordnung, mit denen von außen auf die Modulanordnung zugegriffen werden kann bzw. über die die Modulanordnung - im verbundenen und eingebauten Zustand - auf externe Geräte, Bauteile, Elemente, Systeme etc. einwirken kann, gebündelt und auf der Unterseite versammelt. Die Oberseite dient beispielsweise im Gegensatz dazu zum Aussenden der elektromagnetischen Signale. Alternativ oder ergänzend werden die Signale über eine Seitenfläche der Modulanordnung ausgestrahlt.

Eine Ausgestaltung sieht vor, dass auf einer Unterseite der Modulanordnung Ball Grid Array Lotkugeln vorhanden sind. Alternativ oder ergänzend sind sog. "Heat Balls" zum Abführen der Wärme auf der Unterseite platziert.

Eine Ausgestaltung besteht darin, dass die Antennenvorrichtung eine unterbrochene Abstrahlfläche aufweist.

Eine Ausgestaltung sieht vor, dass die Antennenvorrichtung eine geschlossene Abstrahlfläche aufweist.

Die Abstrahlfläche befindet sich in einer Ausgestaltung auf der Oberseite der Modulanordnung und damit gegenüber der Unterseite mit den nach außen geführten Kontakten der Modulanordnung.

Die Antennenvorrichtung verfügt in einer Ausgestaltung über eine - geschlossene oder unterbrochene - Metallfläche, die in einer Ausgestaltung auf der Oberseite der Modulanordnung die Abstrahlfläche darstellt.

In einer Ausgestaltung weist die Antennenvorrichtung ein Element auf oder besteht in einer weiteren Ausgestaltung aus mehreren Elementen, die zu einem Array zusammengefasst sind.

Die Antennenvorrichtung wird in einer Ausgestaltung beaufschlagt durch eine vertikale Zuleitung, durch sog. "Proximity feed", durch sog. "Aperture coupled feed" oder durch planare Zuleitungen.

Die Antennenvorrichtung weist je nach Ausgestaltung beispielweise mindestens eine Patchantenne, eine Grid Array-Antenne oder eine Schlitzantenne auf. Alternativ weist sie mindestens eine Antenne mit einem Wellenleiter auf, der zumindest teilweise durch ein Antennensubstrat gebildet wird. In anderen Ausgestaltungen sind Dipol-, Monopol-, Yagi-Uda- oder Vivaldi-Antennen beispielsweise vorgesehen. In alternativen oder ergänzenden Ausgestaltungen sind rekonfigurierbare und/oder kleine Antennen (sog. "electrically small antenna", die sehr klein gegenüber ihrer Radiansphere gemäß der Definition von H. A. Wheeler sind) vorgesehen. Andere Varianten und Konfigurationen sind ebenfalls realisierbar.

Eine Ausgestaltung besteht darin, dass Kontaktierungsanschlüsse der elektronischen Komponenten einer Oberseite der Modulanordnung zugewandt sind. In dieser Ausgestaltung sind die Komponenten so angeordnet, dass ihre Kontaktierungsanschlüsse in Richtung der Oberseite der Modulanordnung liegen. Sollen in einer Ausgestaltung die Kontakte zur Kontaktierung der Modulanordnung auf der Unterseite liegen, so sind entsprechende Verbindungsstrukturen von den Kontaktierungsanschlüssen zu der Unterseite vorzusehen.

Eine Ausgestaltung sieht vor, dass die mindestens eine elektronische Komponente ein Chip (z. B. ein RF-Chip) und/oder ein passives elektronisches Bauteil (z. B. Induktivität, Kondensator, elektrischer Widerstand, Filter, Schalter oder Richtkoppler) ist.

In einer Ausgestaltung wird wenigstens eine elektronische Komponente direkt in die Träger-Schicht eingebettet und/oder erzeugt. Die so in der Träger-Schicht eingebettete elektronische Komponente ist beispielweise als Kondensator ausgestaltet, der sich vorzugsweise in der Nähe der aktiven Komponenten, z. B. der Chips befindet. So lässt sich die Energieverteilung stabilisieren. Alternativ oder ergänzend sind Induktivitäten als elektronische Komponenten vorgesehen.

Eine Ausgestaltung besteht darin, dass mindestens eine elektronische Komponente - insbesondere unmittelbar oder zumindest nur über einen thermisch leitfähigen Kleber - mit einem Kühlkörper verbunden ist. Der Kühlkörper ist dabei beispielweise mit einer Seite der zugehörigen Komponente verbunden.

In einer Ausgestaltung ist die mindestens eine elektronische Komponente über einen Metallkern mit einem Kühlkörper thermisch verbunden ist. Der Metallkern lässt sich alternativ als Metallschicht bezeichnen. Der Metallkern ist dabei ein Teil der Modulanordnung.

In einer Ausgestaltung ist die mindestens eine elektronische Komponente über mindestens eine Durchkontaktierung (sog. "thermal via") mit einem Kühlkörper thermisch verbunden ist.

In einer weiteren Ausgestaltung ist die mindestens eine elektronische Komponente über einen Metallkern und über mindestens eine Durchkontaktierung mit einem Kühlkörper thermisch verbunden ist. Dies ist somit die Kombination der beiden vorgenannten Ausgestaltungen.

Gemäß einer Ausgestaltung weist die Modulanordnung im Bereich der Antennenvorrichtung Löcher auf.

Eine Ausgestaltung sieht vor, dass das Antennensubstrat, das die Antennenvorrichtung trägt, im Bereich der Antennenvorrichtung Löcher aufweist. In einer alternativen oder ergänzenden Ausgestaltung weist die Träger-Schicht, die die Antennenvorrichtung trägt, im Bereich der Antennenvorrichtung Löcher auf. Die Löcher bilden in einer Ausgestaltung eine photonische Bandlückenstruktur (englisch "photonic bandgap structure"), die Oberflächenwellen filtert. Alternativ oder ergänzend reduzieren die Löcher die Permittivität des Substrats, das die Antennenvorrichtung trägt. Die Ausgestaltung mit den Löchern erlaubt es, größer dimensionierte Antennenstrukturen im Millimeterwellen- oder Terahertz-Bereich zu verwenden. Die größeren Abmessungen reduzieren dabei auch die Auswirkungen von Fertigungstoleranzen. Alternativ oder ergänzend sind elektromagnetische Bandlückenstrukturen in der Modulanordnung vorhanden.

Eine Ausgestaltung besteht darin, dass ein Abstandselement (ein sog. "spacer") vorhanden ist. Dabei ist das Abstandselement im Bereich der Antennenvorrichtung angeordnet. Weiterhin ist das Abstandselement entweder zwischen einer Oberseite der Modulanordnung und der Antennenvorrichtung angeordnet oder das Abstandselement ist zwischen einer Unterseite der Modulanordnung und der Antennenvorrichtung angeordnet. In einer Ausgestaltung befindet sich das Abstandselement unterhalb der Antennenvorrichtung, so dass die Antennenvorrichtung möglichst nah der Oberseite der Modulanordnung ist. Die Verwendung des Abstandselements erlaubt es, dass das Antennensubstrat, das die Antennenvorrichtung trägt, eine andere und insbesondere geringere Höhe als die elektronischen Komponenten aufweist. Der Höhenunterschied wird dann durch das Abstandselement ausgeglichen.

In einer Ausgestaltung sind die Komponenten und die Antennenvorrichtung bzw. das die Antennenvorrichtung tragende Antennensubstrat so angeordnet, dass sie in Richtung einer Seite (z. B. der Oberseite) der Modulanordnung eine plane Oberfläche bilden. In Richtung der gegenüberliegenden Seite (somit als Beispiel die Unterseite) werden Höhenunterschiede durch das Abstandselement ausgeglichen, so dass sich ebenfalls eine plane Oberfläche ergibt.

Eine Ausgestaltung sieht vor, dass die Modulanordnung ein Antennensubstrat aufweist. Dabei trägt das Antennensubstrat die Antennenvorrichtung. Das Antennensubstrat ist dabei in einer Ausgestaltung als Dielektrikum ausgeführt. Die Wahl des Materials des Antennensubstrats ist dabei auch von den Eigenschaften der Antennenvorrichtung abhängig. Eine Ausgestaltung besteht darin, dass das Antennensubstrat ein Teil der Träger-Schicht ist. In einer Ausgestaltung wird die Antennenvorrichtung direkt auf und/oder in der Träger-Schicht hergestellt. In einer alternativen Ausgestaltung wird die Antennenvorrichtung in eine Teil-Schicht integriert und diese Teil-Schicht wird mit einer anderen Teil-Schicht, die die elektronischen Komponenten trägt, zu der Träger-Schicht zusammengefügt.

Eine Ausgestaltung sieht vor, dass die Antennenvorrichtung separat zu der Modulanordnung gefertigt ist. In dieser Ausgestaltung ist die Antennenvorrichtung auf einem separaten Antennensubstrat gefertigt und wird anschließend in die Träger-Schicht eingebettet oder wird alternativ so mit der Träger-Schicht verbunden, dass sich die Antennenvorrichtung und die mindestens eine elektronische Komponente in einer Ebene befinden.

Eine Ausgestaltung besteht darin, dass die Modulanordnung eine Ergänzungsschicht aufweist. In einer Ausgestaltung ist die Ergänzungsschicht eine Leiterplatte. Die Ergänzungsschicht ist dabei entweder zwischen einer Oberseite der Modulanordnung und der Träger-Schicht oder zwischen einer Unterseite der Modulanordnung und der Träger-Schicht angeordnet. In einer Ausgestaltung befindet sich die Ergänzungsschicht von der Ober- zur Unterseite der Modulanordnung aus betrachtet unterhalb der Träger-Schicht. In dieser Ausgestaltung fungiert die Ergänzungsschicht vorzugsweise auch als Temperierungsschicht, indem passende Strukturen oder Elemente vorhanden sind, um die Wärme der elektronischen Komponenten in Richtung der Unterseite abzuführen.

In einer weiteren Ausgestaltung ist die Ergänzungsschicht so ausgestaltet und so relativ zu der Träger-Schicht und/oder relativ zu mindestens einer elektronischen Komponente angeordnet, dass die Ergänzungsschicht eine Höhendifferenz zwischen mindestens einer elektronischen Komponente und der Antennenvorrichtung bzw. deren Antennensubstrat ausgleicht. In einer Ausgestaltung besteht daher die Ergänzungsschicht aus einem thermisch gut leitfähigen Material, z. B. einem entsprechenden Dielektrikum.

In einer Ausgestaltung ist vorgesehen, dass die Modulanordnung mindestens eine Deckschicht aufweist, und dass die Deckschicht zwischen einer Oberseite und der Träger-Schicht angeordnet ist. Die Deckschicht befindet sich somit oberhalb der Träger-Schicht und damit auch oberhalb der Antennenvorrichtung.

In einer Ausgestaltung befindet sich die Träger-Schicht zwischen mindestens einer Ergänzungsschicht und mindestens einer Deckschicht. In dieser Ausgestaltung strahlt die Antennenvorrichtung vorzugsweise nur in seitlicher Richtung.

In einer Ausgestaltung ist eine Struktur zur Fokussierung der Strahlung der Antennenvorrichtung vorhanden. Die Struktur ist beispielsweise eine Linse. In einer Ausgestaltung ist die Struktur oberhalb der Antennenvorrichtung angeordnet. In einer weiteren Ausgestaltung befindet sich die Struktur seitlich an der Modulanordnung.

Weiterhin löst die Erfindung die Aufgabe durch ein Verfahren zum Erzeugen einer Modulanordnung.

Das Verfahren sieht dabei vor, dass die Modulanordnung so erzeugt wird, dass sich in einer Ebene und nebeneinander eine Antennenvorrichtung und mindestens eine elektronische Komponente befinden und dass sich zwischen der Antennenvorrichtung und der mindestens einen elektronischen Komponente eine Abschirmvorrichtung befindet, die derartig ausgestaltet ist, eine abschirmende Wirkung gegenüber elektromagnetischen Signalen zu haben.

Eine Ausgestaltung des Verfahrens beinhaltet, dass in einer Träger-Schicht die Antennenvorrichtung und die mindestens eine elektronische Komponente eingebettet werden.

Die obigen Ausgestaltungen der Modulanordnung lassen sich durch entsprechende Schritte des Herstellungsverfahrens realisieren, so dass die obigen Ausführungen auch hier gelten. Daher wird auf eine Wiederholung verzichtet.

Im Einzelnen gibt es eine Vielzahl von Möglichkeiten, die erfindungsgemäße Modulanordnung sowie das Verfahren auszugestalten und weiterzubilden. Dazu wird verwiesen einerseits auf die Patentansprüche, andererseits auf die folgende Beschreibung von Ausführungsbeispielen in Verbindung mit der Zeichnung. Es zeigen:
- Fig. 1: einen Schnitt durch eine schematische Darstellung einer ersten Ausgestaltung der Modulanordnung,
- Fig. 2: einen Schnitt durch eine schematische Darstellung einer zweiten Ausgestaltung der Modulanordnung,
- Fig. 3: einen Schnitt durch eine schematische Darstellung einer dritten Ausgestaltung der Modulanordnung,
- Fig. 4: einen Schnitt durch eine schematische Darstellung einer vierten Ausgestaltung der Modulanordnung,
- Fig. 5: einen Schnitt durch eine schematische Darstellung einer fünften Ausgestaltung der Modulanordnung,
- Fig. 6: einen Schnitt durch eine schematische Darstellung einer sechsten Ausgestaltung der Modulanordnung,
- Fig. 7: einen Schnitt durch eine schematische Darstellung einer siebten Ausgestaltung der Modulanordnung,
- Fig. 8: einen Schnitt durch eine schematische Darstellung einer achten Ausgestaltung der Modulanordnung,
- Fig. 9: einen Schnitt durch eine schematische Darstellung einer neunten Ausgestaltung der Modulanordnung,
- Fig. 10: einen Schnitt durch eine schematische Darstellung einer zehnten Ausgestaltung der Modulanordnung,
- Fig. 11: einen Schnitt durch eine schematische Darstellung einer elften Ausgestaltung der Modulanordnung,
- Fig. 12: einen Schnitt durch eine schematische Darstellung einer zwölften Ausgestaltung der Modulanordnung,
- Fig. 13: eine Draufsicht auf eine schematische Darstellung einer Modulanordnung,
- Fig. 14: Draufsichten auf zwei unterschiedliche Ausgestaltungen der Modulanordnung,
- Fig. 15: einen Schnitt durch eine schematische Darstellung einer weiteren Ausgestaltung der Modulanordnung.

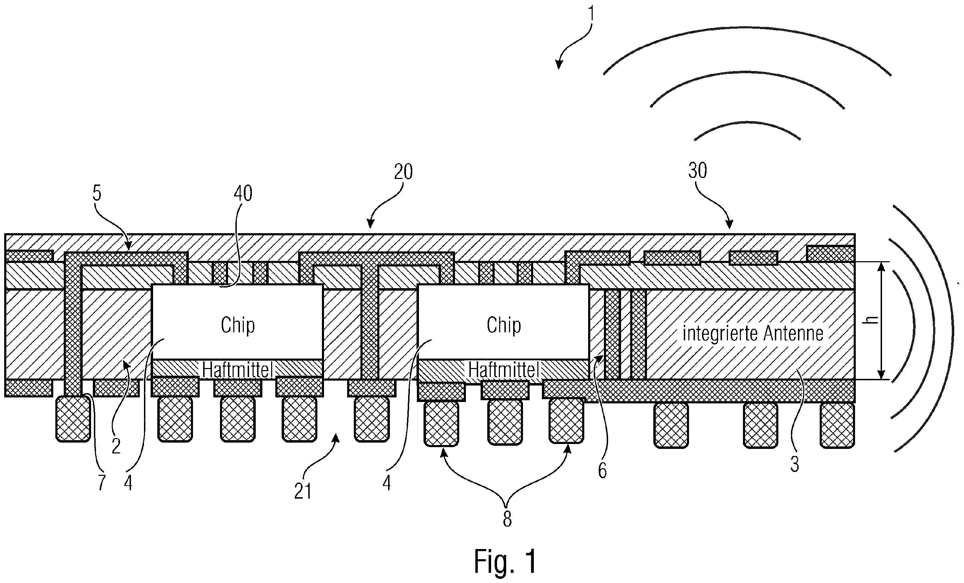

Die Modulanordnung 1 der Fig. 1 verfügt über eine Leiterplatte als ein Beispiel für die Träger-Schicht 2, in der eine Antennenvorrichtung 3 integriert sowie zwei Chips als elektronische Komponenten 4 eingebettet sind.

Ausgehend von einer Oberseite 20 der Modulanordnung 1, die in der gezeigten Ausgestaltung auch eine Oberseite der Träger-Schicht 2 ist, hin zu einer Unterseite 21 der Modulanordnung 1 bzw. der Träger-Schicht 2 befinden sich die elektronischen Komponenten 4 und die Antennenvorrichtung 3 zumindest teilweise auf der gleichen Höhe und zumindest in der gleichen Ebene, die hier die Träger-Schicht 2 ist.

Die Antennenvorrichtung 3 ist zumindest zum Aussenden von elektromagnetischen Signalen ausgestaltet, was hier durch die Wellen angedeutet ist. Die Signale werden dabei in vertikaler (also senkrecht auf der Oberseite 20 der Modulanordnung 1) und in azimutaler Richtung (also ausgehend von einer Seitenfläche der Modulanordnung 1) bei der gezeigten Ausgestaltung ausgesendet. Hierfür verfügt die Antennenvorrichtung 3 über eine passende Abstrahlfläche 30, die sich in der gezeigten Ausgestaltung auf der Oberseite 20 der Modulanordnung 1 befindet. Das Material der Träger-Schicht 2, das sich im Bereich der Antennenvorrichtung 3 befindet und das damit auch das Antennensubstrat bildet, hat dabei Auswirkungen auf die Eigenschaften der Antennenvorrichtung 3. Relevant ist dabei auch die Dicke der Träger-Schicht 2 in diesem Areal, so dass hier die Höhe h eingezeichnet ist.

Die Antennenvorrichtung 3 befindet sich an einer Seite bzw. am Rand der Modulanordnung 1, so dass die elektromagnetischen Signale in einer Richtung ungehindert aus der Träger-Schicht 2 austreten können. In Richtung der elektronischen Komponenten 4 sind für deren Schutz vor den Signalen zwei zueinander versetzt angeordnete Reihen von Durchkontaktierungen (sog. "Vias") als Abschirmvorrichtung 6 vorgesehen.

Für die Verbindung der elektronischen Komponenten 4 untereinander bzw. für die Ansteuerung der Antennenvorrichtung 3 ist eine Verteilungsschicht 5 vorgesehen, in der die erforderlichen Strukturen, Verbindungen oder allgemein Leitungen eingebracht sind.

Zu erkennen ist, dass die elektronischen Komponenten - hier die Chips - 4 ihre Kontaktierungsanschlüsse 40 jeweils in Richtung der Oberseite 20 aufweisen. Daher verlaufen auch die Verbindungen zwischen den Komponenten 4 bzw. zwischen den Komponenten 4 und der Antennenvorrichtung 3 in der Verteilungsschicht 5, die gesehen von der Unterseite 21 oberhalb der Träger-Schicht 2 angeordnet ist.

Diejenigen Kontaktierungsanschlüsse 40 der Komponenten 4, die eine Verbindung nach außen erlauben, werden zu der Unterseite 21 der Modulanordnung 1 geführt und münden dort in Kontakten 7 zur Kontaktierung der Modulanordnung 1.

Für die Befestigung der Modulanordnung 1 auf einem - hier nicht dargestellten - Trägerelement oder sonstigem Bauteil usw. sind auf der Unterseite 21 Ball Grid Array Lotkugeln 8 (alternativ: "Heat Balls") vorhanden.

Bei den folgenden Ausgestaltungen werden, um Wiederholungen zu vermeiden, hauptsächlich nur die Unterschiede zur Ausführung der Fig. 1 diskutiert.

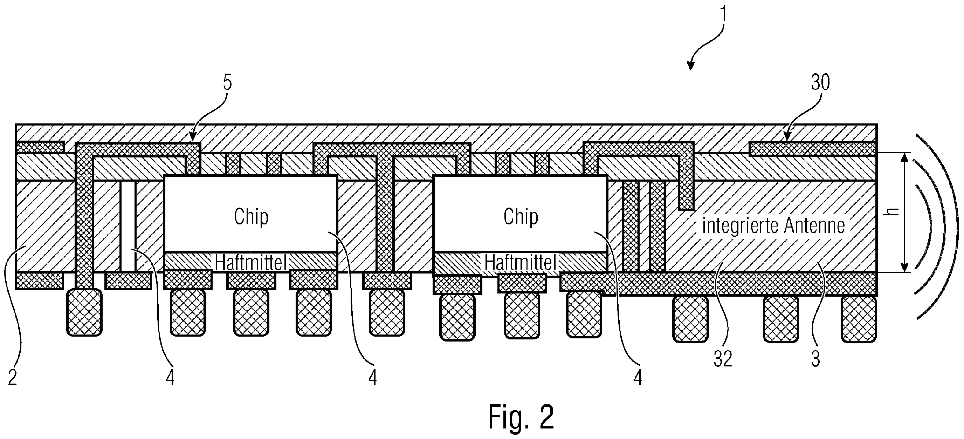

Die Ausgestaltung der Fig. 2 unterscheidet sich von der Variante der Fig. 1 darin, dass die Abstrahlfläche 30 der Antennenvorrichtung 3 der Fig. 1 unterbrochen und in der Fig. 2 geschlossen ist. In der Variante der Fig. 2 bewirkt dies, dass die elektromagnetischen Signale nur seitlich ausgesendet werden. Zu erkennen ist auch, dass eine Verbindung zwischen einem Chip 4 und der Antennenvorrichtung 3 in das Antennensubstrat 32 hineinführt. Das Antennensubstrat 32 ist hierbei ein Teil der Träger-Schicht 2. Es wird somit deutlich, dass die Antennenvorrichtung 3 in der Träger-Schicht 2 eingebettet ist.

Weiterhin ist in der Träger-Schicht 2 der Fig. 2 noch ein passives Bauteil als elektronische Komponente 4 eingebracht, bei dem es sich z. B. um einen Kondensator, eine Spule, einen Widerstand, eine Diode oder um einen Schalter handelt. Die Kontaktierung des passiven Bauteils findet dabei wie bei den beiden Chips 4 über die Verteilungsschicht 5 statt.

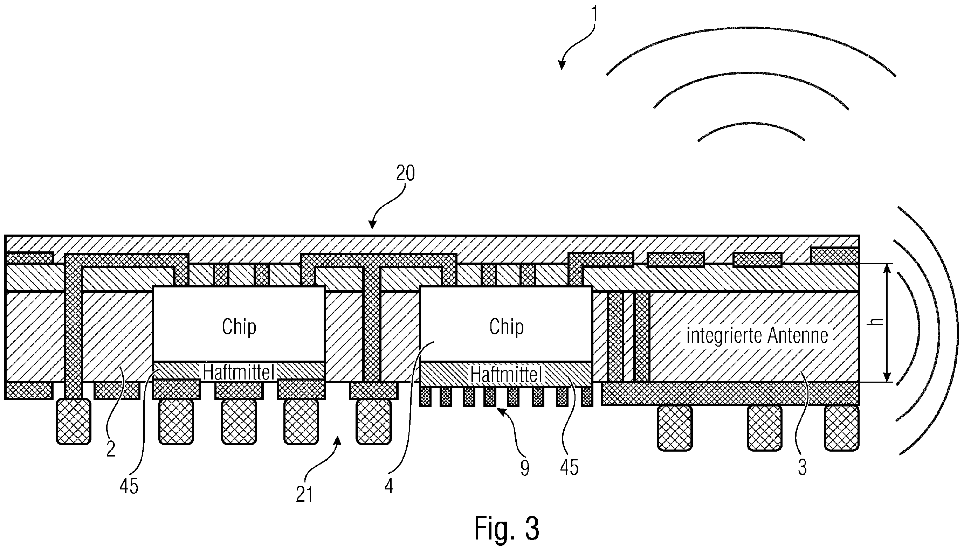

Die Fig. 3 zeigt eine Ausgestaltung, bei der ein Chip 4 an seiner Oberseite, die sich hier in Richtung der Unterseite 21 der Modulanordnung 1 befindet, mit einem Kühlkörper 9 zum Abführen der Wärme verbunden ist. Für die Verbindung zwischen dem Chip 4 und dem Kühlkörper 9 ist dabei ein Kleber 45 vorgesehen.

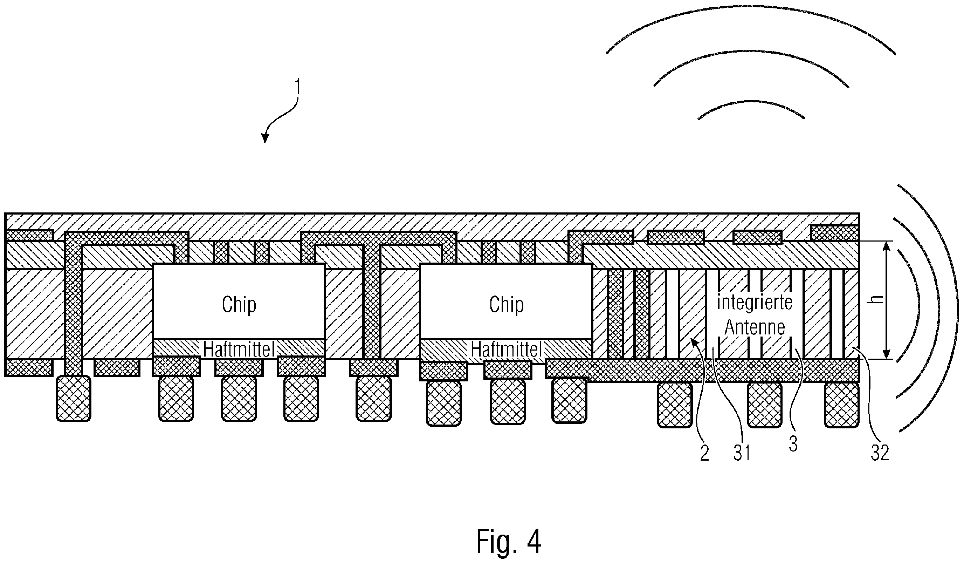

Bei dem Ausführungsbeispiel der Fig. 4 strahlt die Antennenvorrichtung 3 in vertikaler und azimutaler Richtung elektromagnetische Signale aus. Das Antennensubstrat 32, das hier ebenfalls ein Teil der Träger-Schicht 2 ist, ist mit Löchern 31 im Bereich der integrierten Antennenvorrichtung 3 versehen. Die Löcher 31 sind dabei insbesondere derartig ausgestaltet und angeordnet, dass sich eine photonische Bandlückenstruktur ergibt, um Oberflächenwellen zu filtern. Weiterhin erniedrigt sich so die Permittivität des Antennensubstrats 32, was daher auch Auswirkungen auf die Eigenschaften der Antennenvorrichtung 3 hat.

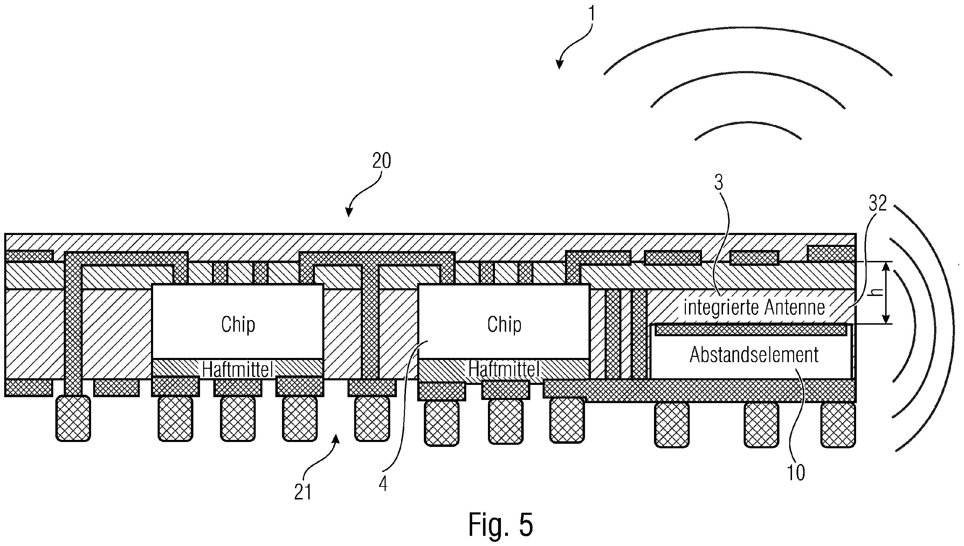

Bei den Varianten der Fig. 1 bis 4 haben jeweils die Komponenten 4 die gleiche Höhe wie das Antennensubstrat 32 bzw. wie der Bereich, über den sich die Antennenvorrichtung 3 erstreckt. Nachteilig an der Abhängigkeit der Höhe des Antennensubstrats 32 von den Abmessungen der elektronischen Komponenten 4 ist, dass damit auch die Sende- und Empfangseigenschaften der Antennenvorrichtung 3 von diesen Abmessungen abhängig sind. Vorteilhafter ist es jedoch in einigen Anwendungen, wenn das Antennensubstrat 32 dünner ausgeführt ist. Die Höhe h des Antennensubstrats 32 ist somit in einigen Ausgestaltungen kleiner als die Höhe der elektronischen Komponenten 4. Dies ist in der Fig. 5 dargestellt.

Um trotz des Höhenunterschieds eine plane Unterseite 21 zu erhalten, befindet sich in dem dargestellten Ausführungsbeispiel unterhalb der Antennenvorrichtung 3 und damit in Richtung der Unterseite 21 ein Abstandselement 10 (sog. "Spacer"), das für den erforderlichen Höhenausgleich sorgt.

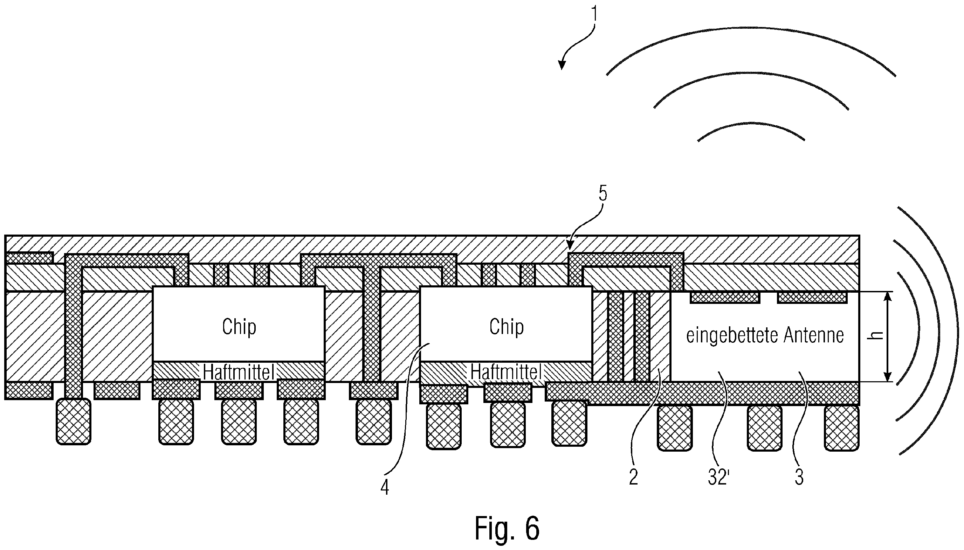

Die Antennenvorrichtung 3 der Ausgestaltung der Fig. 6 ist separat von der Träger-Schicht 2 gefertigt und anschließend in die Träger-Schicht 2 eingebettet worden. Zudem sind auch die erforderlichen Verbindungen zwischen den elektronischen Komponenten 4 und der Antennenvorrichtung 3 über die Verteilungsschicht 5 vorhanden. Die Antennensubstanz 32' der Antennenvorrichtung 3 besteht hier aus einem anderen Material als die Träger-Schicht 2, z. B. Glas.

Diese Ausgestaltung der Modulanordnung 1 der Fig. 6 bezieht sich somit auf eine separat oder eigenständig erzeugte Antennenvorrichtung 3, die als Ganzes - und damit auch mit ihrem Antennensubstrat 32' - in der Träger-Schicht 2 eingebettet wird. Dabei bezieht sich die Einbettung in einer Ausgestaltung darauf, dass die Antennenvorrichtung 3 von der Träger-Schicht 2 umgeben ist. In einer alternativen Ausgestaltung wird die Antennenvorrichtung 3 seitlich mit der Träger-Schicht 2 fest verbunden, wobei sich Antennenvorrichtung 3 und elektronische Komponenten 4 in einer gemeinsamen Ebene befinden.

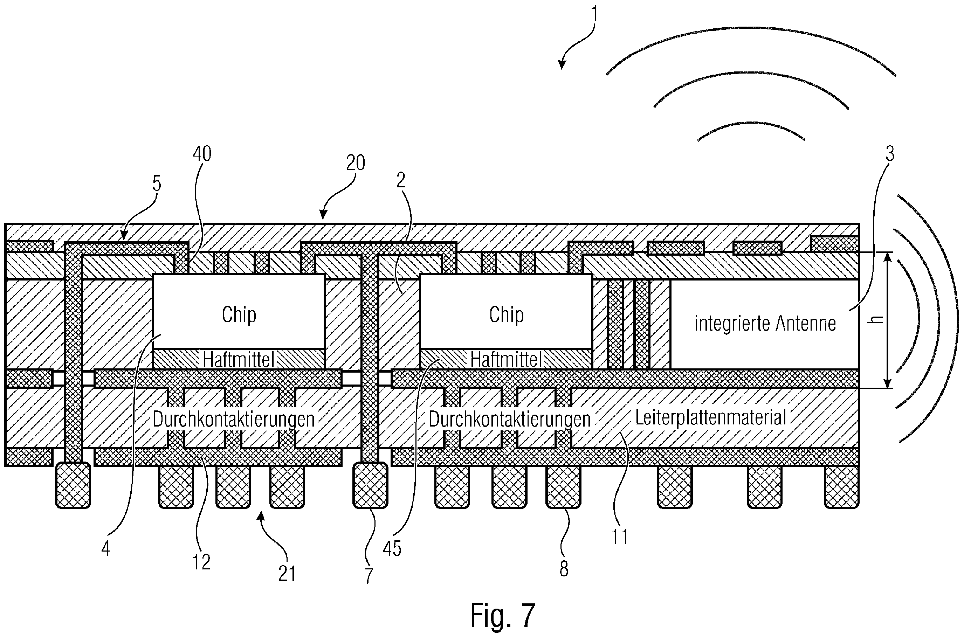

Bei der Variante der Fig. 7 ist unterhalb der Träger-Schicht 2 eine Ergänzungsschicht 11 vorhanden und mit der Träger-Schicht 2, z. B. über einen Kleber 45 oder über eine Prepreg-Schicht verbunden.

Die Ergänzungsschicht 11, die in einer Ausgestaltung wie die Träger-Schicht 2 aus einem üblichen Leiterplattenmaterial besteht, dient auch der Temperierung der elektronischen Komponenten 4. Dies geschieht über thermisch wirkende Durchkontaktierungen (sog. "Thermal Vias") 12, die sich unterhalb der elektronischen Komponenten 4 befinden und die im dargestellten Ausführungsbeispiel auf der Unterseite 21 der Modulanordnung 1 münden.

Zu der Unterseite 21 sind auch die Kontaktierungsanschlüsse 40 der Komponenten 4 heruntergeführt, die eine Verbindung nach außen erlauben, d. h. sie enden auf den Kontakten 7 der Modulanordnung 1.

In der Träger-Schicht 2 sind in der gezeigten Ausgestaltung die elektronischen Komponenten 4 und die Antennenvorrichtung 3 einbettet und liegen daher in einer Ebene.

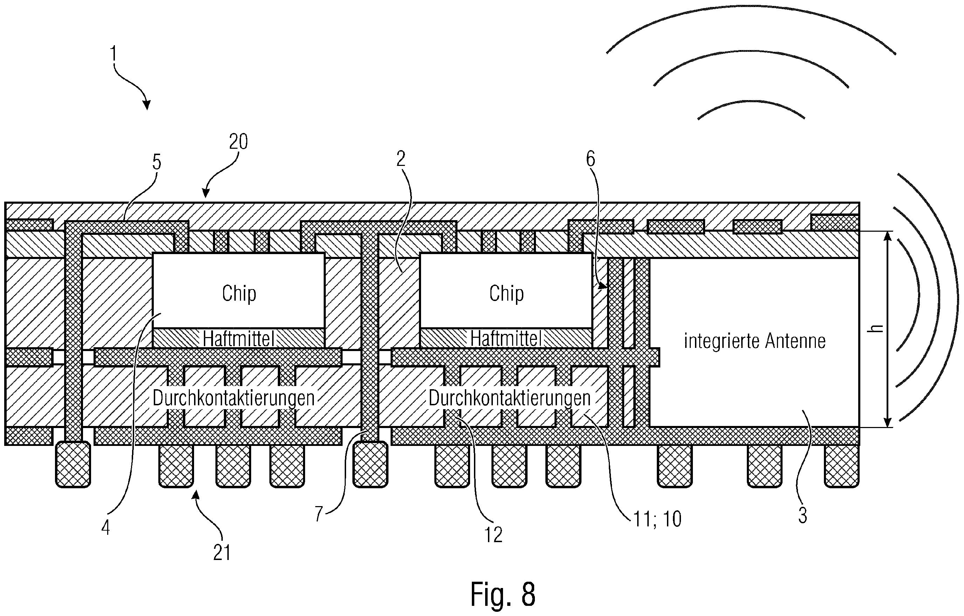

Bei der Variante der Fig. 8 befindet sich die Ergänzungsschicht 11 nur unterhalb des Teils der Träger-Schicht 2, der die elektronischen Komponenten 4 trägt. Die Antennenvorrichtung 3 ist hier deutlich höher als die elektronischen Komponenten 4 ausgeführt, so dass die - z. B. aus einer Leiterplatte gebildete - Ergänzungsschicht 11 hier die Rolle des Abstandselements 10 übernimmt und den Höhenausgleich zwischen den elektronischen Komponenten 4 und der Antennenvorrichtung 3 erzeugt.

Die Komponenten 4 und die Antennenvorrichtung 3 sind dabei in eine gemeinsame Träger-Schicht 2 eingebettet, die sich aus zwei Teilen ergibt: ein Teil mit einer geringeren Höhe für die Komponenten 4 und ein Teil mit einer größeren Höhe für die Antennenvorrichtung 3. Beide Teile werden entsprechend miteinander und auch mit der Ergänzungsschicht 11 verbunden.

Die über die gesamte Höhe durchgehenden Durchkontaktierungen als Abschirmvorrichtung 6 schützen dabei auch hier die elektronischen Komponenten 4 vor den elektromagnetischen Signalen der Antennenvorrichtung 3.

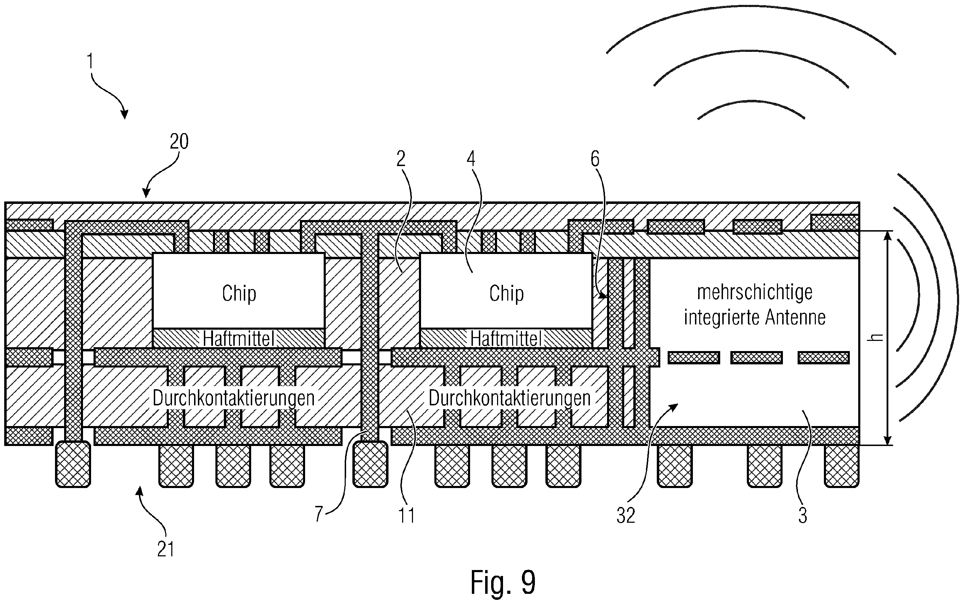

Der Unterschied zwischen der Variante der Fig. 8 und der der Fig. 9 besteht darin, dass die Antennenvorrichtung 3 ihre Höhe h durch mehrere Lagen oder Schichten erreicht. So ist hier ein Teil der Struktur der Antennenvorrichtung 3 beispielhaft auch mittig eingezeichnet. Das Antennensubstrat 32 setzt sich damit zusammen aus der Träger-Schicht 2 und auch aus der Ergänzungsschicht 11. Somit sind weiterhin die Antennenvorrichtung 3 und die elektronischen Komponenten 4 in einer gemeinsamen Trägerschicht 2 eingebunden bzw. befinden sich beide in einer gemeinsamen Ebene. Die Antennenvorrichtung 3 ragt jedoch hier über die gemeinsame Ebene hinaus und befindet sich damit in der dargestellten Ausgestaltung in der Ergänzungsschicht 11.

Auch hier dient die Oberseite 20 und eine Seitenfläche der Ausstrahlung der elektromagnetischen Signale der Antennenvorrichtung 3. Auf der Unterseite 21 sind die Kontakte 7 angeordnet, die die Kontaktierung der Modulanordnung 1 erlaubt, und befinden sich die Bereiche zum gezielten Abführen der erzeugten Wärme.

Zwischen den elektronischen Komponenten 4 und der Antennenvorrichtung 3 befinden sich auch in der Variante der Fig. 9 mehrere in zwei zueinander versetzt angeordneten Reihen angeordnete Durchkontaktierungen als Abschirmvorrichtung 6 zur Trennung in Bezug auf elektromagnetische Signale.

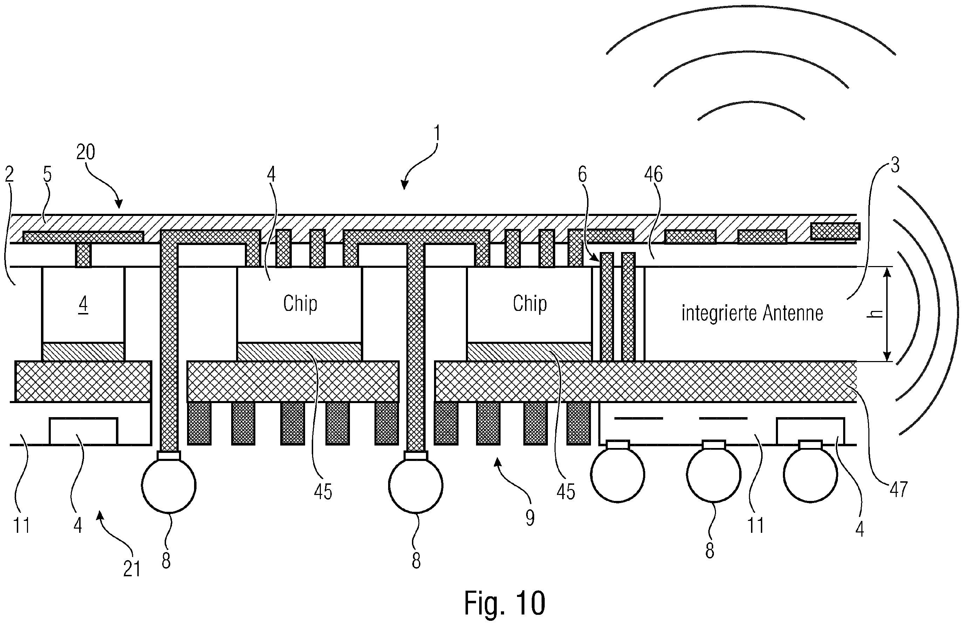

In der Ausgestaltung der Modulanordnung 1 der Fig. 10 sind in der Träger-Schicht 2 mehrere elektronische Komponenten 4 sowie die integrierte Antennenvorrichtung 3 nebeneinander angeordnet. Zwischen einem Chip als elektronischer Komponente 4 und der Antennenvorrichtung 3 befinden sich mehrere Abschirmvorrichtungen 6, die hier als in zwei zueinander versetzt angeordneten Reihen angeordnete Durchkontaktierungen (sog. shielding vias) ausgeführt sind und eine abschirmende Wirkung in Bezug auf die Strahlung der Antennenvorrichtung 3 haben. Die elektromagnetisch abschirmend wirkenden Durchkontaktierungen 6 erstrecken sich dabei hinein in die PrePreg-Schicht 46, die sich oberhalb der Träger-Schicht 2 befindet und der Kontaktierung weiterer Schichten dient. Hier ist dies die Verteilungsstruktur 5.

Die elektronischen Komponenten 4 sind mittels eines thermisch leitfähigen Klebers 45 auf einem Metallkern 47 fixiert. Unterhalb des Metallkerns (alternative Bezeichnung ist: Metallschicht) 47 befindet sich eine Ergänzungsschicht 11, die auch weitere elektronische Komponenten 4 aufnimmt.

Auf dem Metallkern 47 und thermisch mit diesem verbunden, sind in den Bereichen unterhalb der beiden Chips 4 Kühlkörper 9 vorgesehen, die der Abfuhr der Wärme der Chips dienen.

Die Strukturen zur elektrischen Kontaktierung der beiden Chips der hier dargestellten elektronischen Komponenten 4 münden jeweils auf Lotkugeln 8, die sich auf der gleichen Höhe wie die anderen Lotkugeln 8 befinden, die auf der Unterseite der Ergänzungsschicht 11 ruhen.

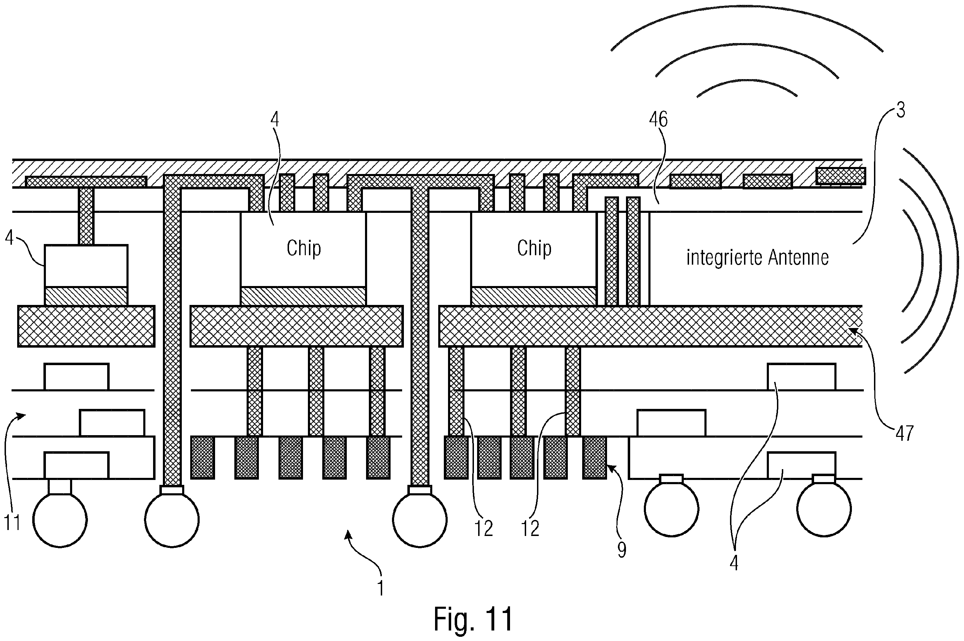

Die Kühlfunktion der Modulanordnung 1 der Fig. 11 unterscheidet sich von dem Kühlmechanismus der Modulanordnung 1 der Fig. 10, indem der Metallkern 47 mit Durchkontaktierungen (sog. thermal vias) 12 thermisch kontaktiert ist und indem die Durchkontaktierungen 12 wiederum auf Kühlkörpern 9 enden.

Weiterhin befinden sich unterhalb des Metallkerns 47 mehrere Ergänzungsschichten 11, in die elektronische Komponenten 4 eingebettet sind.

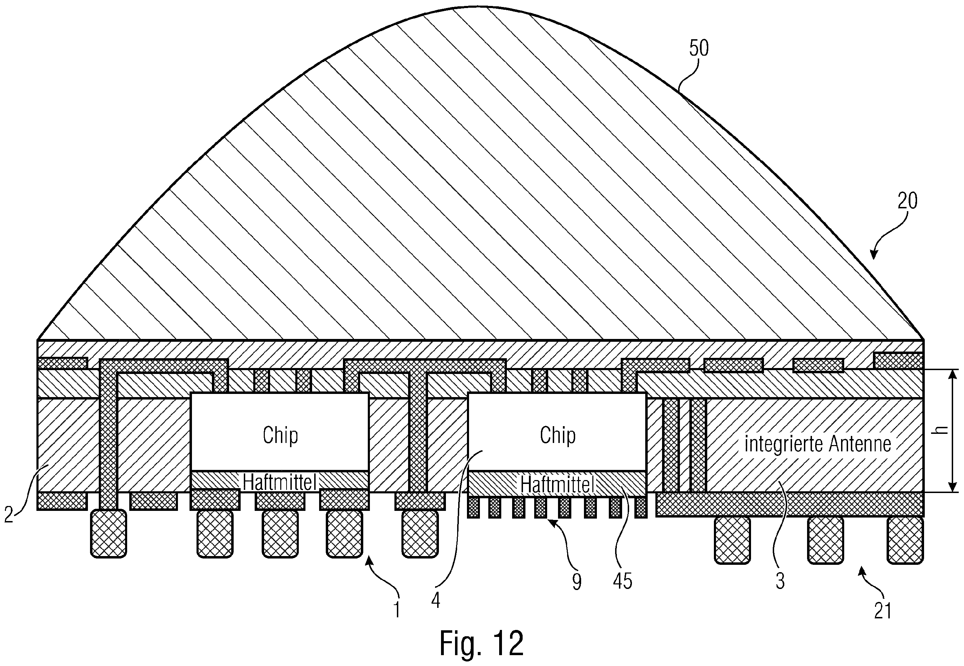

Die Modulanordnung 1 der Fig. 12 verfügt über eine Struktur 50 zur Fokussierung der Strahlung der Antennenvorrichtung 3. Die Struktur 50 ist hier beispielhaft als Linse ausgeführt. Je nach Ausgestaltung befindet sich die Struktur 50 nur oberhalb der Abstrahlrichtung der Antennenvorrichtung 3 oder oberhalb der gesamten Oberseite 20 der Modulvorrichtung 1.

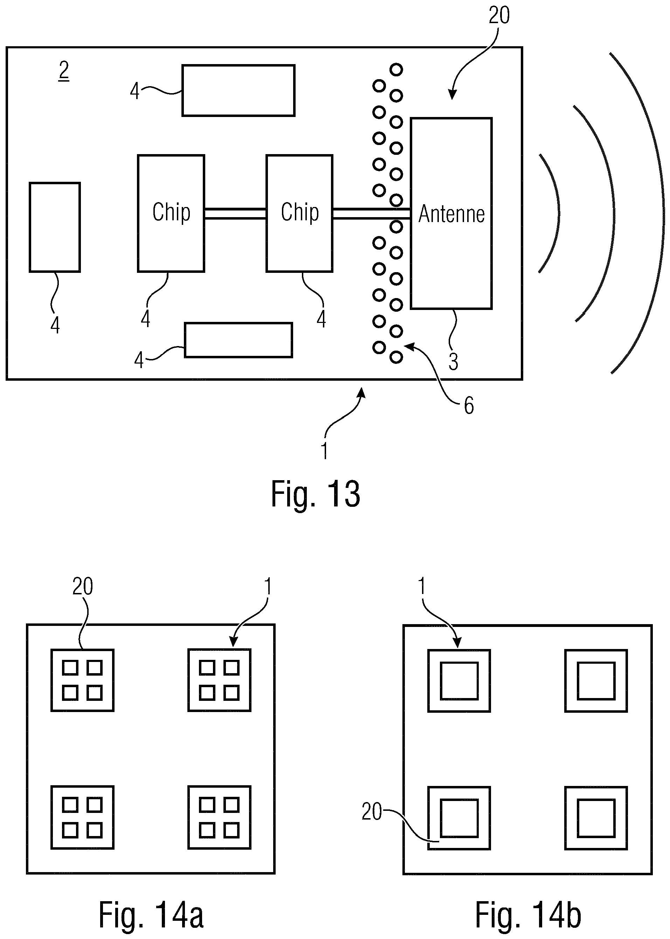

Die Fig. 13 zeigt eine beispielhafte Anordnung von elektronischen Komponenten 4 und der Antennenvorrichtung 3 innerhalb der Träger-Schicht 2 einer Modulanordnung 1. Die beiden als Chips ausgeführten elektronischen Komponenten 4 sind dabei miteinander und mit der Antennenvorrichtung 3 verbunden, um beispielsweise die Antennenvorrichtung 3 entsprechend mit Signalen zu beaufschlagen. Die Antennenvorrichtung 3 strahlt hier seitlich elektromagnetische Signale aus.

Zwischen den elektronischen Komponenten 4 und der Antennenvorrichtung 3 befindet sich eine Abschirmvorrichtung 6, die hier durch zwei versetzt zueinander angeordnete Reihen von Durchkontaktierungen (sog. shielding vias) gebildet wird. Durch diese Durchkontaktierungen besteht ein elektromagnetischer Schutz zwischen den elektronischen Komponenten 4 und der Antennenvorrichtung 3.

Die Fig. 14 zeigt zwei Vorrichtungen, die jeweils über vier Modulanordnungen 1 verfügen. Die Modulanordnungen 1 sind hier beispielhaft jeweils in 2 * 2-Matrizen angeordnet.

Weiterhin unterscheiden sich die Modulanordnungen 1 jeweils dadurch, dass die jeweilige Oberseite 20 entweder unterbrochen (Fig. 14 a)) oder durchgehend geschlossen ist (Fig. 14 b)).

Die einzelnen Modulanordnungen 1 werden in Bezug auf die Abstrahlung durch die jeweiligen Antennenvorrichtungen entweder einzeln oder im Verbund angesteuert, sodass sich jeweils unterschiedliche Abstrahleigenschaften ergeben.

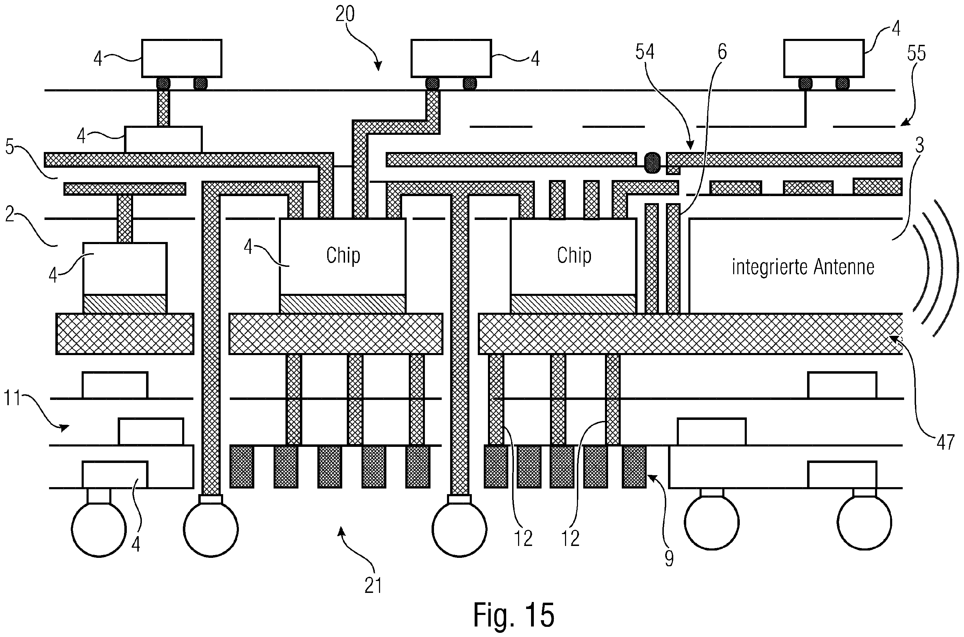

Die Modulanordnung 1 der Fig. 15 verfügt unterhalb der Träger-Schicht 2 über mehrere Ergänzungsschichten 11 mit eingebetteten elektronischen Komponenten 4 und oberhalb der Träger-Schicht 2 noch über Deckschichten 55. In den Deckschichten 55 sind elektronische Komponenten 4 eingebettet und auf den Deckschichten 55 befinden sich zudem noch weitere elektronische Komponenten 4.

Zwischen den Deckschichten 55 und der Träger-Schicht 2 mit der Antennenvorrichtung 3 befindet sich eine Abschirmschicht (shielding layer) 54, die eine Abschirmung in Bezug auf elektromagnetische Strahlung zwischen der Antennenvorrichtung 3 und den elektronischen Komponenten 4 der Deckschichten 55 bewirkt.

Zu erkennen ist, dass die elektronischen Komponenten 4 der Träger-Schicht 2 mit den elektronischen Komponenten 4 der Deckschicht 55 und mit den elektronischen Komponenten 4 oberhalb der Deckschichten 55 verbunden sind. Weiterhin ist die Kontaktierung der elektronischen Komponenten 4 der Träger-Schicht 2 zu weiteren externen Komponenten usw. zur Unterseite 21 der Modulanordnung 1 geführt. Gleiches gilt für die Kühlstruktur, die hier über den Metallkern 47, die als "thermal vias" ausgestalteten Durchkontaktierungen 12 sowie über die Kühlkörper 9 realisiert ist.

Die Deckschichten 55 und die Abschirmschicht 54 bewirken, dass die Antennenvorrichtung 3 in der gezeigten Ausgestaltung der Modulanordnung 1 nur zur Seite abstrahlt. Obwohl manche Aspekte im Zusammenhang mit einer Vorrichtung beschrieben wurden, versteht es sich, dass diese Aspekte auch eine Beschreibung des entsprechenden Herstellungsverfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Modulanordnung (1),
aufweisend eine Antennenvorrichtung (3), mindestens eine elektronische Komponente (4) und eine dielektrische Trägerschicht (2),
wobei zwischen einer Oberseite (20) und einer Unterseite (21) der Modulanordnung (1) die Antennenvorrichtung (3) und die mindestens eine elektronische Komponente (4) nebeneinander in der dielektrischen Trägerschicht (2) angeordnet sind,
**dadurch gekennzeichnet, dass** zwischen der Antennenvorrichtung (3) und der mindestens einen elektronischen Komponente (4) eine Abschirmvorrichtung (6) vorhanden ist,
wobei die Abschirmvorrichtung (6) eine abschirmende Wirkung gegenüber elektromagnetischen Signalen hat, und
wobei die Abschirmvorrichtung (6) durch zwei zueinander versetzt angeordnete Reihen von Durchkontaktierungen, sogenannten shielding vias, gebildet ist.

2. Modulanordnung (1) nach Anspruch 1, wobei die dielektrische Träger-Schicht (2) als eine Leiterplatte ausgeführt ist.

3. Modulanordnung (1) nach einem der vorhergehenden Ansprüche, wobei eine Verteilungsschicht (5) zum Verteilen von elektrischer Energie und/oder elektrischen Signalen vorhanden ist.

4. Modulanordnung (1) nach einem der vorhergehenden Ansprüche,
wobei die mindestens eine elektronische Komponente (4) mit einem Kühlkörper (9) thermisch verbunden ist.

5. Modulanordnung (1) nach einem der vorhergehenden Ansprüche, wobei die mindestens eine elektronische Komponente (4) an einer Seite, die der Unterseite (21) der Modulanordnung (1) zugewandt ist, mit einem Kühlkörper (9) zum Abführen von Wärme verbunden ist.

6. Modulanordnung (1) nach einem der vorhergehenden Ansprüche,
wobei die mindestens eine elektronische Komponente (4) über einen Metallkern (47) mit einem Kühlkörper (9) thermisch verbunden ist.

7. Modulanordnung (1) nach einem der Ansprüche 1 bis 5,
wobei die mindestens eine elektronische Komponente (4) über mindestens eine Durchkontaktierung (12) mit einem Kühlkörper (9) thermisch verbunden ist.

8. Modulanordnung (1) nach einem der Ansprüche 1 bis 5,
wobei die mindestens eine elektronische Komponente (4) über einen Metallkern (47) und über mindestens eine Durchkontaktierung (12) mit einem Kühlkörper (9) thermisch verbunden ist.

9. Modulanordnung (1) nach einem der vorhergehenden Ansprüche, wobei Kontaktierungsanschlüsse (40) der mindestens einen elektronischen Komponente (4) zu der Unterseite (21) der Modulanordnung (1) geführt sind und dort auf Kontakten (7) zur Kontaktierung der Modulanordnung (1) enden.

10. Modulanordnung (1) nach Anspruch 9,
wobei die Kontakte (7) zur Kontaktierung der Modulanordnung (1) auf einer Unterseite (21) der Modulanordnung (1) zusammengeführt sind.

11. Modulanordnung (1) nach einem der Ansprüche 9 der 10,
wobei die Kontaktierungsanschlüsse (40) der mindestens einen elektronischen Komponente (4) einer Oberseite (20) der Modulanordnung (1) zugewandt sind.

12. Modulanordnung (1) nach einem der vorhergehenden Ansprüche,
wobei ein Abstandselement (10) vorhanden ist, und
wobei das Abstandselement (10) im Bereich der Antennenvorrichtung (3) zwischen einer Unterseite (21) der Modulanordnung (1) und der Antennenvorrichtung (3) angeordnet ist.

13. Modulanordnung (1) nach einem der vorhergehenden Ansprüche,
wobei die Modulanordnung (1) ein Antennensubstrat (32, 32') aufweist, und
wobei das Antennensubstrat (32) die Antennenvorrichtung (3) trägt.

14. Modulanordnung (1) nach Anspruch 13, wobei das Antennensubstrat (32) ein Teil der dielektrischen Träger-Schicht (2) ist.

15. Modulanordnung (1) nach einem der vorhergehenden Ansprüche,
wobei die Antennenvorrichtung (3) als ein separat von der Modulanordnung (1) gefertigtes Bauteil ausgestaltet ist.

16. Modulanordnung (1) nach einem der vorhergehenden Ansprüche,
wobei die Modulanordnung (1) mindestens eine Ergänzungsschicht (11) aufweist, und
wobei die Ergänzungsschicht (11) zwischen einer Unterseite (21) der Modulanordnung (1) und der dielektrischen Träger-Schicht (2) angeordnet ist.

17. Modulanordnung (1) nach einem der vorhergehenden Ansprüche,
wobei die Modulanordnung (1) mindestens eine Deckschicht (55) aufweist, und
wobei die Deckschicht (55) zwischen einer Oberseite (20) und der dielektrischen Träger-Schicht (2) angeordnet ist.

18. Modulanordnung (1) nach einem der vorhergehenden Ansprüche,
wobei eine Struktur (50) zur Fokussierung der Strahlung der Antennenvorrichtung (3) vorhanden ist.

19. Modulanordnung (1) nach einem der vorhergehenden Ansprüche,
wobei die Modulanordnung (1) im Bereich der Antennenvorrichtung (3) Löcher (31) aufweist.

20. Verfahren zur Herstellung einer Modulanordnung (1) nach einem der vorhergehenden Ansprüche,
wobei die Modulanordnung (1) so erzeugt wird, dass sich zwischen einer Oberseite (20) und einer Unterseite (21) der Modulanordnung (1) die Antennenvorrichtung (3) und die mindestens eine elektronische Komponente (4) nebeneinander in der dielektrischen Trägerschicht (2) befinden, **dadurch gekennzeichnet, dass** sich zwischen der Antennenvorrichtung (3) und der mindestens einen elektronischen Komponente (4) eine Abschirmvorrichtung (6) befindet, die derartig ausgestaltet ist, eine abschirmende Wirkung gegenüber elektromagnetischen Signalen zu haben, und
wobei die Abschirmvorrichtung (6) durch zwei zueinander versetzt angeordnete Reihen von Durchkontaktierungen, sogenannten shielding vias, gebildet wird.

## Claims

1. Module arrangement (1),
comprising an antenna device (3), at least one electronic component (4) and a dielectric carrier layer (2),
wherein, between a top side (20) and a bottom side (21) of the module arrangement (1), the antenna device (3) and the at least one electronic component (4) are arranged next to each other in the dielectric carrier layer (2),
**characterized in that** a shielding device (6) is provided between the antenna device (3) and the at least one electronic component (4),
wherein the shielding device (6) has a shielding effect relative to electromagnetic signals, and
wherein the shielding device (6) is formed by two rows of via holes, so-called shielding vias, arranged offset with respect to each other.

2. Module arrangement (1) in accordance with claim 1, wherein the dielectric carrier layer (2) is configured as a circuit board.

3. Module arrangement (1) in accordance with any of the preceding claims,
wherein a distribution layer (5) for distributing electrical energy and/or electrical signals is provided.

4. Module arrangement (1) in accordance with any of the preceding claims, wherein the at least one electronic component (4) is thermally connected to a cooling body (9).

5. Module arrangement (1) in accordance with any of the preceding claims, wherein the at least one electronic component (4) is thermally connected, on a side that faces the bottom side (21) of the module arrangement (1), to a cooling body (9) for dissipating heat.

6. Module arrangement (1) in accordance with any one of the preceding claims,
wherein the at least one electronic component (4) is thermally connected to a cooling body (9) via a metal core (47).

7. Module arrangement (1) in accordance with any of claims 1 to 5,
wherein the at least one electronic component (4) is thermally connected to a cooling body (9) via at least one via hole (12).

8. Module arrangement (1) in accordance with any of claims 1 to 5,
wherein the at least one electronic component (4) is thermally connected to a cooling body (9) via a metal core (47) and via at least one via hole (12).

9. Module arrangement (1) in accordance with any of the preceding claims, wherein contacting terminals (40) of the at least one electronic component (4) are lead to the bottom side (21) of the module arrangement (1) and end there on contacts (7) for contacting the module arrangement (1).

10. Module arrangement (1) in accordance with claim 9,
wherein contacts (7) for contacting the module arrangement (1) are merged on a bottom side (21) of the module arrangement (1).

11. Module arrangement (1) in accordance with any of claims 9 or 10
wherein the contacting terminals (40) of the at least one electronic component (4) face a top side (20) of the module arrangement (1).

12. Module arrangement (1) in accordance with any of the preceding claims,
wherein a spacer (10) is provided, and
wherein the spacer (10) is arranged in the region of the antenna device (3) between a bottom side (21) of the module arrangement (1) and the antenna device (3).

13. Module arrangement (1) in accordance with any of the preceding claims,
wherein the module arrangement (1) comprises an antenna substrate (32, 32'), and
wherein the antenna substrate (32) supports the antenna device (3).

14. Module arrangement (1) in accordance with claim 13,
wherein the antenna substrate (32) is part of the dielectric carrier layer (2).

15. Module arrangement (1) in accordance with any of the preceding claims,
wherein the antenna device (3) is manufactured as an element made separately from the module arrangement (1).

16. Module arrangement (1) in accordance with any of the preceding claims,
wherein the module arrangement (1) comprises at least one complementary layer (11), and
wherein the complementary layer (11) is arranged between a bottom side (21) of the module arrangement (1) and the dielectric carrier layer (2).

17. Module arrangement (1) in accordance with any of the preceding claims,
wherein the module arrangement (1) comprises at least one cover layer (55), and
wherein the cover layer (55) is arranged between a top side (20) and the dielectric carrier layer (2).

18. Module arrangement (1) in accordance with any of the preceding claims,
wherein a structure (50) for focusing the radiation of the antenna device (3) is provided.

19. Module arrangement (1) in accordance with any of the preceding claims,
wherein the module arrangement (1) comprises holes (31) in the region of the antenna device (3).

20. Method for manufacturing a module arrangement (1),
wherein the module arrangement (1) is produced such that, between a top side (20) and a bottom side (21) of the module arrangement (1), the antenna device (3) and the at least one electronic component (4) are located next to each other in the dielectric carrier layer (2), **characterized in that** a shielding device (6) which is implemented so as to exhibit a shielding effect relative to electromagnetic radiation is provided between the antenna device (3) and the at least one electronic component (4), and
wherein the shielding device (6) is formed by two rows of via holes, so-called shielding vias, arranged offset with respect to each other.

## Revendications

1. Ensemble de module (1),
présentant un dispositif d'antenne (3), au moins un composant électronique (4) et une couche de support diélectrique (2),
dans lequel, entre un côté supérieur (20) et un côté inférieur (21) de l'ensemble de module (1), le dispositif d'antenne (3) et l'au moins un composant électronique (4) sont disposés l'un à côté de l'autre dans la couche de support diélectrique (2),
**caractérisé par le fait qu'**entre le dispositif d'antenne (3) et l'au moins un composant électronique (4) est présent un dispositif de blindage (6),
dans lequel le dispositif de blindage (6) a un effet de blindage contre les signaux électromagnétiques, et
dans lequel le dispositif de blindage (6) est formé par deux rangées de trous traversants, appelés vias de blindage, disposés décalés l'un par rapport à l'autre.

2. Ensemble de module (1) selon la revendication 1, dans lequel la couche de support diélectrique (2) est réalisée sous forme de carte de circuit imprimé.

3. Ensemble de module (1) selon l'une des revendications précédentes, dans lequel est présente une couche de distribution (5) destinée à distribuer de l'énergie électrique et/ou des signaux électriques.

4. Ensemble de module (1) selon l'une des revendications précédentes,
dans lequel l'au moins un composant électronique (4) est connecté thermiquement à un dissipateur thermique (9).

5. Ensemble de module (1) selon l'une des revendications précédentes, dans lequel l'au moins un composant électronique (4) est connecté, sur une face qui est orientée vers la face inférieure (21) de l'ensemble de module (1), à un dissipateur thermique (9) pour dissiper la chaleur.

6. Ensemble de module (1) selon l'une des revendications précédentes,
dans lequel l'au moins un composant électronique (4) est connecté thermiquement, par l'intermédiaire d'un noyau métallique (47), à un dissipateur thermique (9).

7. Ensemble de module (1) selon l'une des revendications 1 à 5, dans lequel l'au moins un composant électronique (4) est connecté thermiquement, par l'intermédiaire d'au moins un trou traversant (12), à un dissipateur thermique (9).

8. Ensemble de module (1) selon l'une des revendications 1 à 5, dans lequel l'au moins un composant électronique (4) est connecté thermiquement, par l'intermédiaire d'un noyau métallique (47) et par l'intermédiaire d'au moins un trou traversant (12), à un dissipateur thermique (9).

9. Ensemble de module (1) selon l'une des revendications précédentes, dans lequel les raccordements de contact (40) de l'au moins un composant électronique (4) sont guidés vers la face inférieure (21) de l'ensemble de module (1) et s'y terminent sur des contacts (7) pour la mise en contact de l'ensemble de module (1).

10. Ensemble de module (1) selon la revendication 9,
dans lequel les contacts (7) pour la mise en contact de l'ensemble de module (1) sont réunis sur une face inférieure (21) de l'ensemble de module (1).

11. Ensemble de module (1) selon l'une des revendications 9 à 10, dans lequel les raccordements de contact (40) de l'au moins un composant électronique (4) font face à une face supérieure (20) de l'ensemble de module (1).

12. Ensemble de module (1) selon l'une des revendications précédentes,
dans lequel est présent un élément d'espacement (10), et
dans lequel l'élément d'espacement (10) est disposé dans la zone du dispositif d'antenne (3) entre une face inférieure (21) de l'ensemble de module (1) et le dispositif d'antenne (3).

13. Ensemble de module (1) selon l'une des revendications précédentes,
dans lequel l'ensemble de module (1) présente un substrat d'antenne (32, 32'), et
dans lequel le substrat d'antenne (32) porte le dispositif d'antenne (3).

14. Ensemble de module (1) selon la revendication 13, dans lequel le substrat d'antenne (32) fait partie de la couche de support diélectrique (2).

15. Ensemble de module (1) selon l'une des revendications précédentes,
dans lequel le dispositif d'antenne (3) est conçu comme un composant fabriqué séparément de l'ensemble de module (1).

16. Ensemble de module (1) selon l'une des revendications précédentes,
dans lequel l'ensemble de module (1) présente au moins une couche complémentaire (11), et
dans lequel la couche complémentaire (11) est disposée entre une face inférieure (21) de l'ensemble de module (1) et la couche de support diélectrique (2).

17. Ensemble de module (1) selon l'une des revendications précédentes,
dans lequel l'ensemble de module (1) présente au moins une couche de recouvrement (55), et
dans lequel la couche de recouvrement (55) est disposée entre une face supérieure (20) et la couche de support diélectrique (2).

18. Ensemble de module (1) selon l'une des revendications précédentes,
dans lequel est présente une structure (50) destinée à concentrer le rayonnement du dispositif d'antenne (3).

19. Ensemble de module (1) selon l'une des revendications précédentes,
dans lequel l'ensemble de module (1) présente des trous (31) dans la zone du dispositif d'antenne (3).

20. Procédé de fabrication d'un ensemble de module (1) selon l'une des revendications précédentes,
dans lequel l'ensemble de module (1) est généré de sorte que, entre une face supérieure (20) et une face inférieure (21) de l'ensemble de module (1), le dispositif d'antenne (3) et l'au moins un composant électronique (4) soient situés l'un à côté de l'autre dans la couche de support diélectrique (2),
**caractérisé par le fait qu'**entre le dispositif d'antenne (3) et l'au moins un composant électronique (4) se trouve un dispositif de blindage (6) qui est conçu de manière à avoir un effet de blindage contre les signaux électromagnétiques, et
dans lequel le dispositif de blindage (6) est formé par deux rangées de trous traversants, appelés vias de blindage, disposés décalés l'un par rapport à l'autre.
